# EUROPEAN PATENT APPLICATION

(11) **EP 2 357 878 A2**
(43) Date of publication of application: **17.08.2011**
(21) Application number: 11000541.0
(22) Date of filing: 24.01.2011
(51) Int. Cl.: H05K 7/20, G06F 1/20, H02B 1/56

(54) **Cooling system for electronic apparatus**

(30) Priority: 04.02.2010 JP 2010023307
(71) Applicant: Hitachi Plant Technologies, Ltd., Tokyo 170-8466 (JP)
(72) Inventor: Shimokawa, Ryoji, Tokyo 170-8466 (JP); Senda, Masakatsu, Tokyo 170-8466 (JP); Kashirajima, Yasuhiro, Tokyo 170-8466 (JP); Ito, Junichi, Tokyo 170-8466 (JP); Nagatakiya, Asahi, Tokyo 170-8466 (JP)
(74) Representative: Strehl Schübel-Hopf & Partner

(57) **Abstract**

A cooling system (10) for an electronic apparatus, includes: a casing (26) in which the electronic apparatus is housed; an evaporator (34) which is disposed at a rear surface side of the casing, and cools heat released from the electronic apparatus by a refrigerant; a slide mechanism (50) which connects the casing and the evaporator to be movable in a longitudinal direction with respect to the casing; at least any one of a cooling tower (38) which is provided at a higher place than the evaporator and condenses the refrigerant by cooling of external air and sprinkled water, and a heat exchanger (54) which cools the refrigerant by using chilled water; a circulation line (40, 64) which moves the refrigerant between the evaporator and at least one of the cooling tower and the heat exchanger; and a piping (78, 80) which connects the circulation line and the evaporator, and is extendable and contractible in response to movement of the evaporator.

## Description

### Field of the Invention

The presently disclosed subject matter relates to a cooling system for an electronic apparatus, and particularly relates to a cooling system for an electronic apparatus for efficiently cooling an electronic apparatus such as a computer or a server which is required to perform a precise operation and generates a large amount of heat from itself.

### Description of the Related Art

In recent years, with improvement of the information processing technique and development of the Internet environments, the information processing amount which is required has been increased, and data processing centers for processing various kinds of information in large volume have been attracting attention as a business. In, for example, the server room of the data processing center, a large number of electronic apparatuses such as a computer and a server are installed in a concentrated state, and are continuously operated day and night. In general, a rack-mount method is mainstream for installation of the electronic apparatuses in server rooms. A rack-mount method is the method in which the racks housing electronic apparatuses by dividing the apparatuses according to functional units are stacked on a cabinet. A number of the cabinets (server racks) are aligned and disposed on the floor of a server room. The electronic apparatuses which process information are rapidly improved in processing speed and throughput and the amount of heat generation from the electronic apparatuses is steadily increasing.

In such circumstances, Japanese Patent Application Laid-Open No. 2009-081439 proposes the art for efficiently cooling an electronic apparatus. Japanese Patent Application Laid-Open No. 2009-081439 discloses a cooling unit (evaporator) which is a steam compression heat exchange system for promoting cooling of a server rack, and includes an evaporator coil at an outlet door which is hinge-mounted to an air outlet side of the server rack.

### SUMMARY OF THE INVENTION

Incidentally, the cooling unit in Japanese Patent Application Laid-Open No. 2009-081439 is hinge-fixed to the server rack. Therefore, machining is required for the server rack. Further, it is necessary to prepare an exclusive cooling unit adapted to the shape of the server rack.

Further, in the hinge-fixed cooling unit, the cooling unit is sometimes in contact with the adjacent server rack at the time of opening and closing of the cooling unit, and the movable range of the cooling unit may be limited.

The presently disclosed subject matter is made in view of the above circumstances, and has an object to provide a cooling system for an electronic apparatus which can efficiently cool an electronic apparatus such as a computer or a server which is required to perform a precise operation and generates a large amount of heat from itself, with a cooling unit (evaporator) which can be easily installed.

In order to attain the above-described object, a first aspect of the presently disclosed subject matter provides a cooling system for an electronic apparatus, including: a casing in which the electronic apparatus is housed; an evaporator which is disposed at a rear surface side of the casing, and cools heat released from the electronic apparatus by a refrigerant; a slide mechanism which connects the casing and the evaporator to be movable in a longitudinal direction with respect to the casing; at least any one of a cooling tower which is provided at a higher place than the evaporator and condenses the refrigerant by cooling of external air and sprinkled water, and a heat exchanger which cools the refrigerant by using chilled water; a circulation line which moves the refrigerant between the evaporator and at least one of the cooling tower and the heat exchanger; and a piping which connects the circulation line and the evaporator, and is extendable and contractible in response to movement of the evaporator.

According to the presently disclosed subject matter, the high-temperature heat which is generated (discharged) from an electronic apparatus (usually having a fan which takes in air of the apparatus room and discharges the air) is directly subjected to heat exchange with the refrigerant which flows in the evaporator while the heat is in the high-temperature state, and evaporation of the refrigerant is promoted, whereby the transport power for transporting the evaporated refrigerant gas to the cooling tower installed at a higher place than the evaporator or the heat exchanger. Furthermore, the refrigerant gas evaporated in the evaporator has a high temperature, and thereby, the cooling capacity to condense the evaporated refrigerant gas to make the refrigerant gas a refrigerant liquid can be made small. The refrigerant liquid which is cooled and condensed flows down to the evaporator located below the cooling tower, and thereby, the circulation line in which the refrigerant naturally circulates between the evaporator and the cooling tower is constructed.

By constructing the natural circulation line like this, the power cost for transporting the refrigerant is not required. The cooling tower is used, which cools the refrigerant with external air and sprinkled water at the cooling side of the circulation line, the heat source load for cooling can be significantly reduced, and the running cost for cooling the refrigerant can be significantly reduced.

Further, the evaporator slides in the longitudinal direction relatively to the casing, and therefore, does not interfere with the adjacent server rack. Therefore, the space for carrying-in, wiring, maintenance and the like of the electronic apparatus can be ensured at the rear surface side of the casing. Further, the evaporator is not directly mounted to the casing, and therefore, a special evaporator does not have to be prepared in accordance with the shape of each casing.

In order to attain the aforementioned object, a second aspect of the presently disclosed subject matter provides a cooling system for an electronic apparatus, including: a casing in which the electronic apparatus is housed; an evaporator which is disposed at a rear surface side of the casing, and cools heat released from the electronic apparatus by a refrigerant; a slide mechanism which connects the casing and the evaporator to be movable in a longitudinal direction with respect to the casing; a cooling tower which is provided at a higher place than the evaporator and condenses the refrigerant by cooling of external air and sprinkled water; a heat exchanger which cools the refrigerant by using chilled water; a circulation line which moves the refrigerant between the evaporator and the cooling tower; a parallel line which is a channel of the refrigerant, is connected to the circulation line, and is provided so that the heat exchanger and the cooling tower have a parallel relation; a parallelizing control mechanism which controls a refrigerant amount of the refrigerant which is passed to the parallel line from the circulation line; and a piping which connects the circulation line and the evaporator and is extendable and contractible in response to movement of the evaporator.

According to the presently disclosed subject matter, as the device which cools the refrigerant, the heat exchanger which cools the refrigerant is connected in parallel to the circulation line to be configured to have a parallel relation with the cooling tower, in addition to the cooling tower, and the refrigerant amount which is passed to the heat exchanger is controlled with the paralleling control mechanism. Thereby, the cooling tower and the heat exchanger can be efficiently used so that the running cost can be minimized in accordance with the cooling load necessary for condensing the refrigerant gas evaporated in the evaporator.

A third aspect of the presently disclosed subject matter provides the cooling system for an electronic apparatus according to the first or second aspect, wherein the evaporator includes a fan. According to the presently disclosed subject matter, the efficiency of the evaporator can be enhanced by providing the fan in the evaporator.

A fourth aspect of the presently disclosed subject matter provides the cooling system according to any one of the first to third aspects, wherein the slide mechanism is fixed to the casing by a clamp. According to the presently disclosed subject matter, the slide mechanism is fixed to the casing by the clamp, and thereby, the slide mechanism can be fixed to the casing without working the casing. More specifically, the slide mechanism can be fixed to the casing with the electronic apparatus operated. Accordingly, the evaporator can be mounted to the casing with the electronic apparatus operated.

A fifth aspect of the presently disclosed subject matter provides the cooling system according to any one of the first to fourth aspects, wherein the evaporator includes a caster adjustable in height at a bottom part of the evaporator. According to the presently disclosed subject matter, by the caster provided at the bottom part of the evaporator, the evaporator can be easily moved in the longitudinal direction with respect to the casing. Further, the caster includes the height adjusting function, and therefore, the evaporator can be disposed to correspond to the height of the opening portion of the casing.

A sixth aspect of the presently disclosed subject matter provides the cooling system for an electronic apparatus according to any one of the first to the fifth aspects, further including: a stopper which fixes positions of the evaporator and the casing. According to the presently disclosed subject matter, the state in which the evaporator is closely attached to the casing can be kept by the stopper. Thereby, the heat generated from the electronic apparatus can be efficiently cooled with the evaporator.

When the electronic apparatus is carried in, carried out and the like, the evaporator is usually moved to separate from the casing. By fixing the position of the evaporator in this position by the stopper, an accident that the evaporator moves at the time of operation and hurts the operator can be prevented.

A seventh aspect of the presently disclosed subject matter provides the cooling system for an electronic apparatus according to any one of the first to sixth aspects, further including: a frame body which is mounted to an outer periphery of the evaporator and adjusts a size with the casing. According to the presently disclosed subject matter, by mounting the frame body to the outer periphery of the evaporator, the difference in size from the casing can be adjusted. Accordingly, one evaporator can be mounted to a plurality of casings differing in size.

According to the presently disclosed subject matter, a cooling system for an electronic apparatus can be provided, which can efficiently cool an electronic apparatus such as a computer or a server, which is required to perform a precise operation and generates a large amount of heat from itself, with an evaporator which can be easily installed.

### BRIEF DESCRIPTION OF THE DRAWINGS

Fig. 1 is a conceptual view explaining an embodiment of a cooling system for an electronic apparatus of the presently disclosed subject matter;
Fig. 2 is an explanatory view explaining one mode of a server rack and an evaporator according to the presently disclosed subject matter;
Fig. 3 is a view illustrating one mode for fixing positions of the evaporator and the server rack;
Fig. 4 is a view illustrating another mode for fixing the positions of the evaporator and the server rack;
Figs. 5A and 5B are explanatory views illustrating mounting states of the evaporator, the server rack and piping; and
Fig. 6 is an explanatory view illustrating the evaporator, a frame body and the server rack.

### DETAILED DESCRIPTION OF THE PREFERRED EMBODIMENT

Hereinafter, a preferred embodiment of the presently disclosed subject matter will be described in accordance with the attached drawings. The presently disclosed subject matter will be described according to the following preferred embodiment, but the presently disclosed subject matter can be modified by a number of methods without departing from the range of the presently disclosed subject matter, and embodiments other than the present embodiment can be used. Accordingly, all modifications in the range of the presently disclosed subject matter are included in claims.

Hereinafter, a preferred embodiment of a cooling system for an electronic apparatus according to the presently disclosed subject matter will be described in detail in accordance with the attached drawings. As one example of the electronic apparatus, an example of the server placed in a server room will be described.

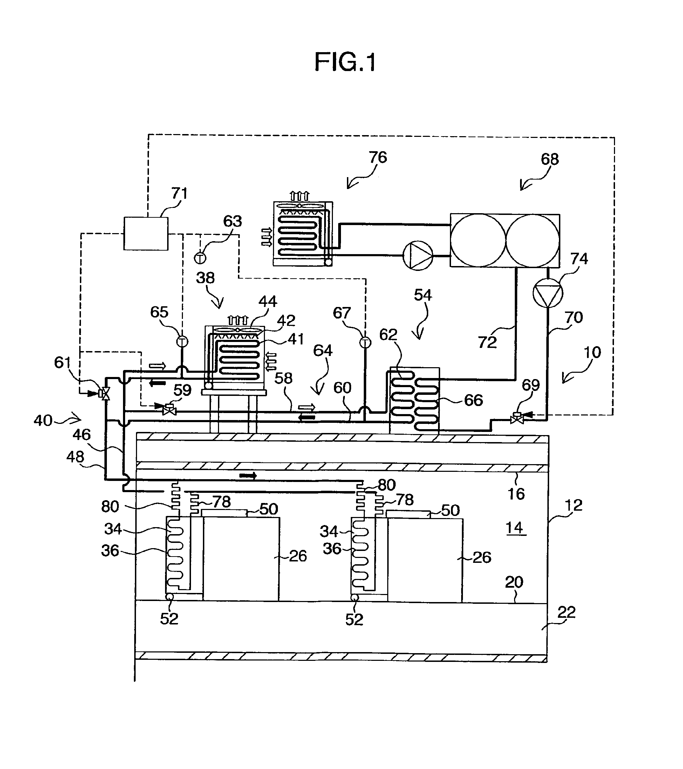

Fig. 1 is a conceptual view illustrating a cooling system 10 for an electronic apparatus of the embodiment of the presently disclosed subject matter. As illustrated in Fig. 1, a server room 14 is provided in a building 12. On the back side of a floor surface 20, an underfloor chamber 22 is formed. On the floor surface 20, a plurality of air outlets (not illustrated) are disposed, and cold air from an air-conditioner (not illustrated) is blown off to the server room 14 from the floor surface 20 through the underfloor chamber 22. The air outlets are preferably disposed near a server rack (casing) 26. Thereby, the cold air which is blown out is supplied to an electronic apparatus (not illustrated) which is housed in the server rack 26. Accordingly, the electronic apparatus is efficiently cooled by cold air.

As illustrated in Fig. 1, an evaporator 34 is disposed at a rear surface side of the server rack 26. The evaporator 34 and the server rack 26 are connected by a slide mechanism 50. By the slide mechanism 50, the evaporator 34 becomes movable in the longitudinal direction with respect to the server rack 26. The evaporator 34 includes a caster 52 on the bottom surface. The evaporator 34 can be easily moved by the caster 52.

The evaporator 34 includes a cooling coil 36 therein. A refrigerant liquid flowing in the cooling coil 36 is evaporated by high-temperature air generated from the electronic apparatus housed in the server rack 26, and thereby, deprives the surroundings of heat of vaporization to be gasified. Thereby, the electronic apparatus and the high-temperature air discharged from the electronic apparatus are cooled.

A cooling tower 38 is installed on the roof of the building 12. A circulation line 40 in which a refrigerant naturally circulates is formed between the cooling tower 38 and the evaporator 34. The cooling tower 38 includes therein spiral piping 41 in which the refrigerant flows, and a water sprinkling pipe 42 which is located above the spiral piping 41 and sprinkles water to the spiral piping 41. The cooling tower 38 includes a fan 44 above the water sprinkling pipe 42. The fan 44 takes in external air from an opening in the side surface of the cooling tower 38, and discharge the external air from an opening on a top surface. A counter current is formed by the sprinkled water and the external air taken in. Thereby, the external air is cooled to be lower than the temperature of the external air when it is taken in.

The cooling coil 36 and the spiral piping 41 are connected by return piping 46 (refrigerant gas piping) for returning the refrigerant gas which is gasified in the evaporator 34 to the cooling tower 38, and supply piping 48 (refrigerant liquid piping) which supplies the refrigerant liquid which is liquefied by cooling and condensing the refrigerant gas in the cooling tower 38 to the evaporator 34. The circulation line 40 is configured by the return piping 46 and the supply piping 48.

The return piping 46 and the supply piping 48 are installed on a ceiling surface 16 of the server room 14. The return piping 46 and the cooling coil 36 of the evaporator 34 are connected by flexible piping 78. Further, the supply piping 48 and the cooling coil 36 of the evaporator 34 are connected by flexible piping 80. The flexible piping 78 and the flexible piping 80 are extendable and contractible, and therefore, even if the evaporator 34 moves relatively to the server rack 26, connection of the return piping 46 and the evaporator 34, and connection of the supply piping 48 and the evaporator 34 are kept.

The amount of heat generation from the electronic apparatuses of recent years has rapidly increased. The high-temperature heat which is generated (discharged) from the electronic apparatus is directly subjected to heat exchange with the refrigerant flowing in the evaporator 34 while the heat is in the high-temperature state to promote evaporation of the refrigerant, whereby a transport power can be obtained, which transports the evaporated refrigerant gas to the cooling tower 38 installed on the place higher than the evaporator 34. As the refrigerant for use, a chlorofluorocarbon, HFC (hydrofluorocarbon) as an alternative chlorofluorocarbon or the like can be used. Further, water can be used, if used at a lower pressure than the atmospheric pressure. Here, expression of the refrigerant includes both a refrigerant gas in a gaseous state and a refrigerant liquid in a liquid state, and in Fig. 1, the direction of the flow of the refrigerant gas is illustrated by the white arrows, and the direction of the flow of the refrigerant liquid is illustrated by the black arrows.

The circulation line 40 for the refrigerant to circulate naturally is formed between the evaporator 34 and the cooling tower 38. By the evaporator 34, the cooling tower 38 and the circulation line 40, a powerless heat pipe in which the refrigerant is sealed is constructed. Further, the amount of heat generation from the electronic apparatus becomes large, and the high-temperature refrigerant gas can be formed. Thereby, the cooling temperature which condenses the refrigerant gas can be set to be high, and the refrigerant gas can be condensed even with the cooling capacity by the cooling tower 38. The condensed refrigerant liquid flows down to the evaporator 34 located below the cooling tower 38.

The evaporator 34 is provided with a temperature sensor (not illustrated) which measures the temperature of the air after the high-temperature air discharged from the electronic apparatus is cooled by the cooling coil 36. The outlet port of the cooling coil 36 is provided with a flow rate regulating device (not illustrated) for regulating the supply flow rate (refrigerant flow rate) of the refrigerant to be supplied to the cooling coil 36. The opening of the flow regulating device (valve) is automatically regulated based on the measured temperature by the temperature sensor. Thereby, when the temperature of the air after cooled in the evaporator 34 becomes excessively lower than the set temperature, the opening of the flow rate regulating device is reduced, and the supply flow rate of the refrigerant is decreased. The supply flow rate of the refrigerant is not increased more than necessary, and thereby, the cooling load for cooling the refrigerant can be made small. Accordingly, sufficient cooling capacity can be exhibited with only the cooling in the cooling tower 38.

Describing this in more detail, the air in the server room 14 is taken into the server rack 26 which houses the electronic apparatus, and is heated by the heat generated from the electronic apparatus. Heat exchange is performed between the heated high-temperature air and the refrigerant in the evaporator 34, and the cooled air is measured by a temperature sensor (not illustrated).

Meanwhile, in the refrigerant natural circulation system, a condensing temperature which is lower than the vaporization (evaporation) temperature is required, unlike the conventional compression type air-conditioning system. Therefore, if the evaporation temperature can be set to be high, the condensing temperature, namely, the temperature of the external air used in the cooling tower 38 can be made high. This means that the cooling capacity in the cooling tower 38 also can be achieved in the condition of the external air at a higher temperature. In the intermediate periods (the spring period and autumn period) when the external air temperature is relatively high, cooling with only the cooling tower can be performed. Thereby, the operation of a chiller 68 is suppressed to realize reduction in running cost.

Further, on the roof of the building 12, a heat exchanger 54 with a larger cooling capacity than the cooling tower 38 is installed, in addition to the cooling tower 38. The heat exchanger 54 is provided in a branch circulation line 64 which is branched from the circulation line 40. As illustrated in Fig. 1, a paralleling return piping 58 and a paralleling supply piping 60 which are branched from the return piping 46 and the supply piping 48 respectively are connected to a secondary side coil 62 of the heat exchanger 54. Thereby, the heat exchanger 54 is disposed with a parallel relation in the flow of the refrigerant with respect to the cooling tower 38.

A primary side coil 66 of the heat exchanger 54 is connected to chilled water supply piping 70 and chilled water return piping 72 from the chiller 68. The chilled water supply piping 70 is provided with a delivery pump 74. Thereby, the chilled water (primary refrigerant) made by the chiller 68 exchanges heat with the refrigerant (secondary refrigerant) in the heat exchanger 54, and cools the refrigerant. The chiller 68, and a cooling tower 76 which is different from the cooling tower 38 are connected, and the cooling tower 76 is used as a heat sink of the chiller 68, whereby the working electric power of the chiller 68 can be reduced. The cooling tower 76 has a similar structure to that of the cooling tower 38.

The paralleling return piping 58 is provided with a paralleling valve 59, and a shut-off valve 61 is provided near the cooling tower 38 in the supply piping 48. A valve 69 is also provided in the chilled water supply piping 70 in which chilled water flows. Meanwhile, an external air temperature sensor 63 which measures an external air temperature is provided in the vicinity of the cooling tower 38. A cooling tower outlet (at the refrigerant liquid side) and a heat exchanger outlet (at the refrigerant liquid side) are respectively provided with temperature sensors 65 and 67. The measurement results of the respective temperature sensors 63, 65 and 67 are inputted into a paralleling control unit 71 one by one. Based on the measurement result, the paralleling control unit 71 controls the respective valves 59, 61 and 69. Thereby, a paralleling control mechanism is formed. The temperature sensors 65 and 67 are provided at the cooling tower outlet and the heat exchanger outlet, but a pressure sensor (not illustrated) which measures the pressure of the refrigerant which flows in the piping can be provided. Further, both the liquid temperature sensors 65 and 67 and the pressure sensor may be provided.

Here, a preferred mode of a control method according to the paralleling control mechanism will be described. The first control method will be described. The paralleling control unit 71 calculates the capacity of being able to cooling the refrigerant in the cooling tower 38 from the measurement result of the external air temperature sensor 63. The amount of the opening of the paralleling valve 59 is regulated from the calculation result, and thereby, the amount of refrigerant which is fed to the heat exchanger 54 is controlled. Thereby, the cooling tower 38 and the heat exchanger 54 can be efficiently used so that the running cost becomes the lowest in accordance with the cooling load required for condensing the refrigerant gas which is evaporated in the evaporator 34.

The cooling capacity of the cooling tower 38 significantly depends on the external air temperature. By performing the control as described above, part of the refrigerant flowing in the circulation line 40 can be made to flow automatically into the heat exchanger 54 in accordance with the variation of the external air temperature. Only the insufficient amount of the cooling capacity of the cooling tower 38 is supplemented by the heat exchanger 54. Thereby, the running cost can be further reduced.

The second control method will be described. The paralleling control unit 71 regulates the amount of the opening of the paralleling valve 59 so that the measurement result of the temperature sensor 65 at the cooling tower outlet becomes a set value. Accordingly, the amount of the refrigerant to be fed to the heat exchanger 54 is controlled. As a result, by measuring the temperature of the refrigerant at the outlet of the cooling tower, the cooling capacity which the cooling tower 38 has at the time point of measurement can be grasped (estimated). Accordingly, by automatically regulating the amount of the opening of the paralleling valve 59 based on the measurement result, part of the refrigerant flowing in the circulation line 40 can be made to flow automatically into the heat exchanger 54, and therefore, only the insufficient amount of the cooling capacity of the cooling tower 38 is supplemented by the heat exchanger 54. As a result, the running cost can be further reduced.

Further, when these control methods are performed, the temperature sensor 67 which is provided at the outlet of the heat exchanger is measured, and thereby, the temperature of the refrigerant to be supplied to the evaporator 34 can be measured. Accordingly, by controlling the amount of the opening of the valve 69 of the cooling water supply piping 70 based on the measurement result, the refrigerant can be prevented from being cooled more than necessary with the heat exchanger 54. Further, in the summer period when the cooling capacity of the cooling tower 38 reduces the most, the combined use of the cooling tower 38 and the heat exchanger 54 may be rather disadvantageous in the aspect of the running cost, and therefore, in such a case, when the measurement temperature of the external air temperature sensor 63 reaches a set value or more, the shut-off valve 61 is closed, whereby the running cost can be further reduced.

In this manner, by having the two cooling devices, that is, the cooling tower 38 and the heat exchanger 54, and causing them to play the respective roles, the stable operation of the cooling system can be ensured, and the running cost for cooling the refrigerant can be reduced.

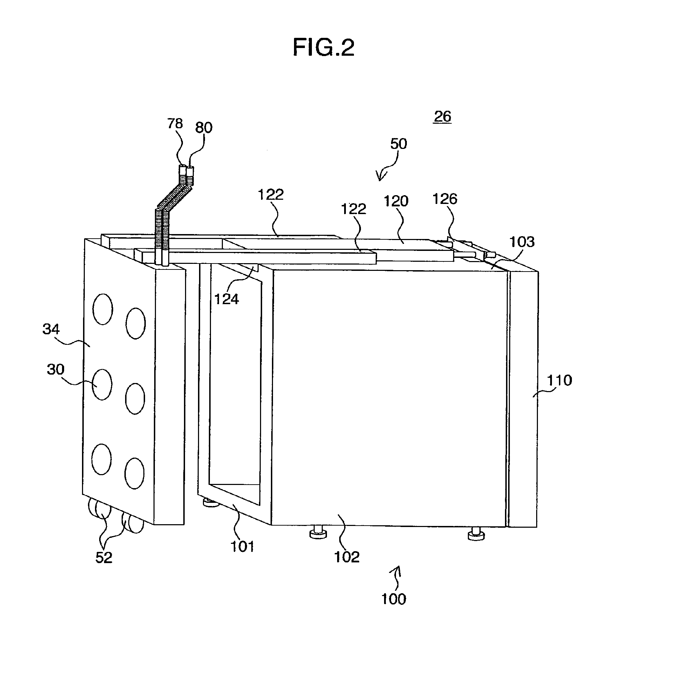

Fig. 2 illustrates one mode of the server rack and the evaporator according to the presently disclosed subject matter. The server rack 26 includes a rack main body 100, and an inlet door 110 mounted to the rack main body 100. The rack main body 100 is configured by a bottom plate 101, a side wall 102 and a ceiling plate 103, and opening portions are formed at a front and a rear. The rack main body 100 has the shape of a square pole as a whole. The rack main body 100 includes a mount angle (not illustrated) for mounting an electronic apparatus therein. The electronic apparatus to be mounted includes a fan therein. External air is fed to the outlet port side (rear surface side) from the inlet port side (front surface side) of the rack main body 100. The bottom plate 101, the side wall 102 and the ceiling plate 103 are made of a material such as stainless steel, a steel material, or a metal subjected to electrolytic plating.

The evaporator 34 is disposed at the rear surface side of the rack main body 100. The evaporator 34 and the rack main body 100 are connected by the slide mechanism 50. The slide mechanism 50 includes a fixed frame 120, and slide rails 122 mounted to both sides of the fixed frame 120. The fixed frame 120 is fixed to the ceiling plate 103 by a clamp which fastens the ceiling plate 103. The clamp is configured by a fixed clamp member 124 and a movable clamp member 126. Actual mounting is performed by fixing the fixed clamp member 124 to one end of the ceiling plate 103, adjusting the movable clamp member 126 to the length of the ceiling plate 103, and fastening the movable clamp member 126 with a bolt or the like.

By fixing the slide mechanism 50 to the ceiling plate 103 with the clamp, the slide mechanism 50 and the ceiling plate 103 can be mounted to each other without applying work to the rack main body 100. Thereby, a boring work or the like to the rack is not required, the adverse effect on the electronic apparatus such as short which is caused by metal cuttings which are generated during work such as boring can be prevented, and the mounting operation can be performed even during operation of the electronic apparatus.

The slide rail 122 is fixed to the evaporator 34 at the end at the side opposite from the fixed frame 120. The slide mechanism 50 enables the evaporator 34 to move in the longitudinal direction with respect to the server rack 26. By sliding the evaporator 34 in the direction to be away from the server rack 26, a space for carrying in/out, wiring, maintenance and the like of the electronic apparatus can be secured at the rear surface side of the server rack 26. In the conventional method which hinge-mounts the evaporator to the server rack, when a plurality of server racks are disposed in parallel, the opening range of a certain evaporator may be limited because the evaporator is in contact with the adjacent server rack, or for the other reasons. In order to avoid the limitation, the conventional method needs to provide a cutout at the hinge side of the evaporator. However, the range for installation of the cooling coil becomes small due to the cutout, and the capacity of the evaporator may become the problem.

Meanwhile, the evaporator 34 capable of sliding movement of the presently disclosed subject matter is not influenced by the adjacent server rack, and therefore, the cooling coil 36 can be installed in the evaporator 34 without any limitation.

In order to connect the return piping and the cooling coil 36, flexible piping 78 is mounted to the evaporator 34. Further, in order to connect the supply piping and the cooling coil 36, flexible piping 80 is mounted to the evaporator 34. Since the flexible piping 78 and the flexible piping 80 are extendable and contractible, the flexible piping 78 and the flexible piping 80 extend and contract to follow the movement of the evaporator 34. Thereby, connection of the return piping and the evaporator 34, and connection of the supply piping and the evaporator 34 are kept. The evaporator 34 of the presently disclosed subject matter is configured to be slidable, and therefore, it is important that the piping which connects the return piping and the evaporator 34 and the piping which connects the supply piping and the evaporator 34 are extendable and contractible.

A caster 52 with a height adjusting function is mounted to a bottom part of the evaporator 34. The caster 52 enables the evaporator 34 to move easily. Further, by adjusting the height of the caster 52, the heights of the evaporator 34 and the rack main body 100 can be adjusted.

A fan 30 is installed at a side opposite from a side of the evaporator 34, which opposes the server rack 26. The external air which is taken into the server rack 26 is fed out to the evaporator 34 by the fan 30. Accordingly, the heat generated from the electronic apparatus is efficiently cooled by the evaporator 34.

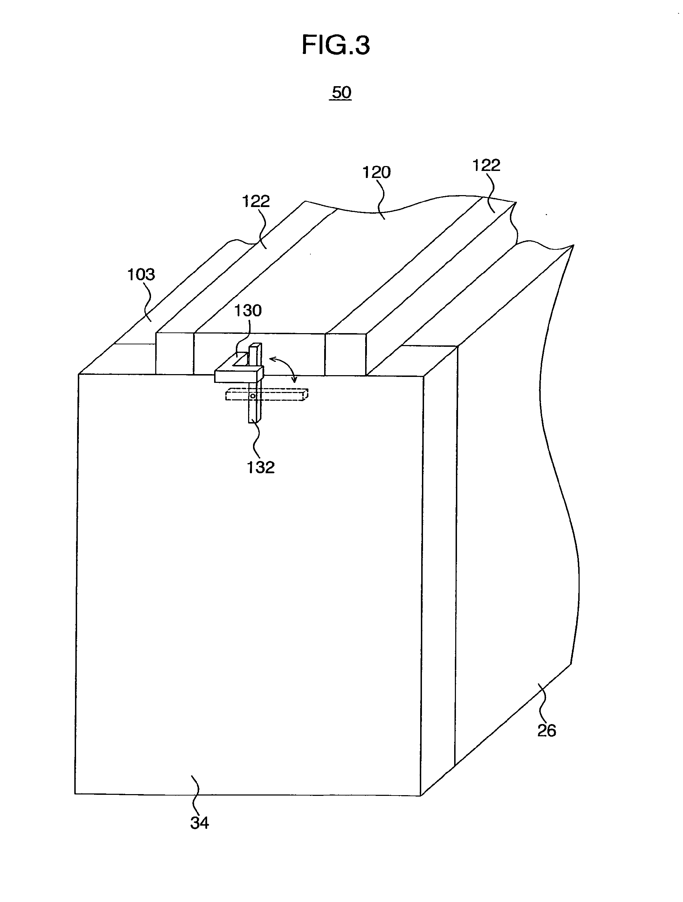

Fig. 3 is a view illustrating one mode for fixing the positions of the evaporator and the server rack. The description of the components similar to those described with Figs. 1 and 2 may be omitted by being assigned with the same reference numerals and characters. As illustrated in Fig. 3, the evaporator 34 is disposed at the position close to the server rack 26. An L-shaped hook 130 is mounted to a rear surface side of the fixed frame 120 fixed to the ceiling plate 103. An arm 132 engaged with the hook 130 is rotatably mounted to the evaporator 34. When the arm 132 is engaged with the hook 130, the evaporator 34 is fixed to the fixed frame 120. Thereby, the evaporator 34 is restrained from sliding movement. The evaporator 34 is closely fixed to the server rack 26, and therefore, heat from the electronic apparatus can be efficiently cooled. Further, unintentional slide movement of the evaporator 34 is restricted, and an accident and the like can be prevented.

By rotating the arm 132 to release the engaged state of the hook 130, the evaporator 34 becomes movable.

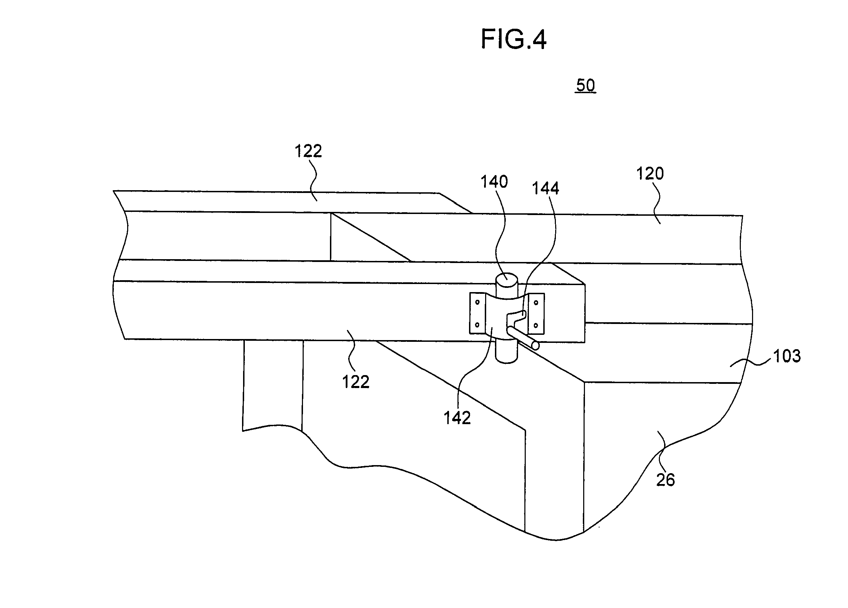

Fig. 4 is a view illustrating another mode for fixing the positions of the evaporator and the server rack. The description of the components similar to those already described may be omitted by assigning the components with the same reference numerals and characters. Fig. 4 illustrates the state in which the slide rail 122 is the most extended with respect to the fixed frame 120. A plate 142 having a guide hole 144, and a metal clasp 140 supported by the guide hole 144 are mounted to the slide rail 122. The metal clasp 140 can freely move along the guide hole 144. In the state in which the slide rail 122 is the most extended with respect to the fixed frame 120, the metal clasp 140 is moved to the lowest position along the guide hole 144. The metal clasp 140 is projected from the plate 142. Thereby, even if a force is applied in the direction to contract the slide rail 122, the metal clasp 140 is in contact with the server rack 26. The metal clasp 140 restrains movement of the slide rail 122. Unintentional slide movement of the evaporator is restricted, and an accident or the like can be prevented.

Meanwhile, when the evaporator is moved, the metal clasp 140 is moved to the highest position along the guide hole 144. The metal clasp 140 is not projected from the plate 142, and the slide rail 122 is in the movable state.

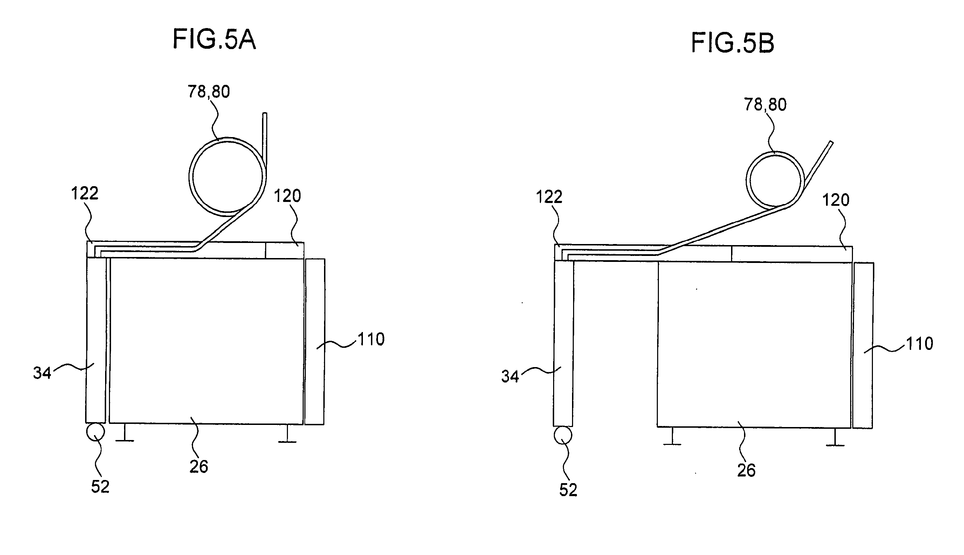

Figs. 5A and 5B illustrate mounting states of the server rack and piping. The description of the components which are similar to those already described may be omitted by assigning the components with the same reference numerals and characters. Fig. 5A illustrates the state in which the evaporator 34 is disposed at the position which is the closest to the server rack 26. The flexible piping 78 and the flexible piping 80 are mounted to the evaporator 34. In order to facilitate the description, only one of the flexible piping is illustrated on the drawing.

The flexible piping 78 and the flexible piping 80 are connected to the evaporator 34 at one ends of them. Further, the flexible piping 78 and the flexible piping 80 are fixed so that parts of them are along the slide rail 122. By fixing the parts of the flexible piping 78 and the flexible piping 80 to the slide rail 122, a load to the joint portion of the flexible piping 78 and the flexible piping 80 and the evaporator 34 can be reduced. Further, the flexible piping 78 and the flexible piping 80 are bundled in a ring shape to be able to contract the diameter between the return piping and the supply piping, and the evaporator 34.

Fig. 5B illustrates the state in which the evaporator 34 is disposed at the position which is the most distant from the server rack 26. The flexible piping 78 and the flexible piping 80 are bundled into a ring shape so as to be able to be reduced in diameter. Accordingly, with the slide movement of the evaporator 34, the diameter of the bundled ring becomes small, and thereby, the flexible piping 78 and the flexible piping 80 extend as they follow the evaporator 34. With the relatively simple configuration, the evaporator, and the return piping and the supply piping can be connected.

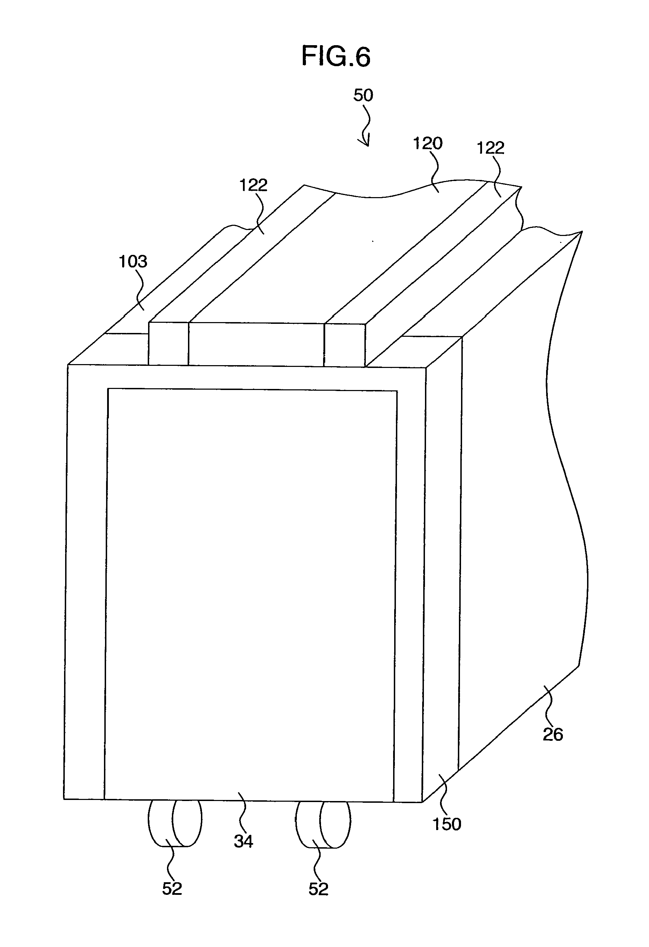

Fig. 6 illustrates the evaporator, the frame body and the server rack. In the present embodiment, with respect to the width direction and the height direction, the server rack 26 has a structure larger than the evaporator 34. In order to supplement the difference in size between the server rack 26 and the evaporator 34, a frame body 150 is mounted to the outer periphery of the evaporator 34. The slide rail 122 is mounted to the frame body 150. Thereby, the difference in size of the server rack 26, the evaporator 34 and the casing can be adjusted. Accordingly, even one evaporator 34 can be adapted to a plurality of server racks 26 differing in size by mounting the frame body 150 to the evaporator 34.

As the server rack 26 becomes larger, the number of electronic apparatuses to be housed there in becomes larger. With this, the heat generation amount also increases, but this can be dealt with by regulating the flow rate and the like of the refrigerant flowing in the evaporator 34.

## Claims

1. A cooling system (10) for an electronic apparatus, comprising:
a casing (26) in which the electronic apparatus is housed;
an evaporator (34) which is disposed at a rear surface side of the casing, and cools heat released from the electronic apparatus by a refrigerant;
a slide mechanism (50) which connects the casing and the evaporator to be movable in a longitudinal direction with respect to the casing;
at least any one of a cooling tower (38) which is provided at a higher place than the evaporator and condenses the refrigerant by cooling of external air and sprinkled water, and a heat exchanger (54) which cools the refrigerant by using chilled water;
a circulation line (40, 64) which moves the refrigerant between the evaporator and at least one of the cooling tower and the heat exchanger; and
a piping (78, 80) which connects the circulation line and the evaporator, and is extendable and contractible in response to movement of the evaporator.

2. A cooling system (10) for an electronic apparatus, comprising:
a casing (26) in which the electronic apparatus is housed;
an evaporator (34) which is disposed at a rear surface side of the casing, and cools heat released from the electronic apparatus by a refrigerant;
a slide mechanism (50) which connects the casing and the evaporator to be movable in a longitudinal direction with respect to the casing;
a cooling tower (38) which is provided at a higher place than the evaporator and condenses the refrigerant by cooling of external air and sprinkled water;
a heat exchanger (54) which cools the refrigerant by using chilled water;
a circulation line (40) which moves the refrigerant between the evaporator and the cooling tower;
a parallel line (64) which is a channel of the refrigerant, is connected to the circulation line, and is provided so that the heat exchanger and the cooling tower have a parallel relation;
a parallelizing control mechanism (71, 59) which controls a refrigerant amount of the refrigerant which is passed to the parallel line from the circulation line; and
a piping (78, 80) which connects the circulation line and the evaporator and is extendable and contractible in response to movement of the evaporator.

3. The cooling system for an electronic apparatus according to claim 1 or 2,
wherein the evaporator includes a fan (30).

4. The cooling system for an electronic apparatus according to any one of claims 1 to 3,
wherein the slide mechanism is fixed to the casing by a clamp (124, 126).

5. The cooling system for an electronic apparatus according to any one of claims 1 to 4,
wherein the evaporator includes a caster (52) adjustable in height at a bottom part of the evaporator.

6. The cooling system for an electronic apparatus according to any one of claims 1 to 5, further comprising:
a stopper (130, 132, 140, 142, 144) which fixes positions of the evaporator and the casing.

7. The cooling system for an electronic apparatus according to any one of claims 1 to 6, further comprising:
a frame body (150) which is mounted to an outer periphery of the evaporator and adjusts a size with the casing.

8. A cooling system in accordance with claim 1 or any claim dependent thereon, comprising the cooling tower (38) and the heat exchanger (54) and further comprising:
a parallel line (64) conducting the refrigerant and connected to the circulation line (40) so that the heat exchanger and the cooling tower are connected in parallel, and
a parallelizing control mechanism (71, 59) for controlling an amount of the refrigerant passing from the circulation line to the parallel line.
